# EUROPEAN PATENT SPECIFICATION

(11) **EP 0 806 589 B1**
(45) Date of publication and mention of the grant of the patent: **13.03.2002**
(21) Application number: 97302722.0
(22) Date of filing: 21.04.1997
(51) Int. Cl.: F16F 15/02, G05D 19/02, H05K 13/08

(54) **Vibration control**
Schwingungsregelung
Régulation de vibration

(30) Priority: 11.05.1996 GB 9609871
(43) Date of publication of application: 12.11.1997
(73) Proprietor: Marconi Caswell Limited, London WIX 8AQ (GB)
(72) Inventor: Salloway, Anthony John, Northampton, Northants NN3 3EP (GB); Humpston, Giles, Aylesbury, Bucks. HP22 4AZ (GB)
(74) Representative: Stanley, Michael Gordon

(56) References cited:
- EP-A- 0 629 869
- US-A- 4 565 940
- US-A- 5 170 103
- PATENT ABSTRACTS OF JAPAN vol. 13, no. 17 (P-813), 17 January 1989 & JP 63 221410 A (RES DEV CORP OF JAPAN ET AL.)

## Description

The present invention relates to vibration control and more particularly to arrangements for controlling the vibration of a planar structure such as a printed circuit board.

The effects of vibration can be reduced through careful attention to design. This usually involves incorporating within the system additional components to damp the amplitude of vibrations. Passive damping systems can be highly effective and are exploited in many instances. However their utilisation invariably increases the overall size and weight of the assembly and they are least effective at low frequencies, that is below a few hundred hertz.

An alternative known method for damping vibrations, particularly of planar structures such as aircraft skin panels and electronic printed circuit boards (PCBs), is to use an active system. A typical implementation comprises a piezoceramic sensor, to detect the vibration mode to be suppressed, and control electronics driving piezoceramic actuators. The actuators are configured so as to oppose the natural bending of the structure, thereby mechanically stiffening it against vibration. Active damping of vibration offers the advantage of low mass, small size and can be effective at low as well as high frequencies, typically many kHz.

To achieve control of vibration on essentially planar structures requires that the actuators are optimally situated. This position is the anti-node of the flexure with the largest amplitude. Frequently, two actuators are used, one each side of the structure, configured such that when one expands the other contracts, thereby providing the desired anti-bending moment.

To provide maximum sensitivity for detecting vibration it is also necessary to place the sensor (which in the known arrangements is a strain gauge) on the anti-node of the flexure with the largest amplitude and this would mean in practice on the actuator itself. Clearly this conflicts with the above mentioned requirement. Co-location of the sensor on the actuator would degrade the system performance because the sensor then measures the strain of the upper surface of the actuator, which is different from that of the panel or PCB. Location of either the sensor or actuator off the anti-node would result in diminished sensing and actuation respectively. This problem would be further compounded by the fact that the strain field developed by the actuator is non-linear, being a maximum immediately adjacent to the actuator and decaying to zero at the panel or PCB edges. Mathematical models predict that the optimum location for an off anti-node strain sensor would be approximately equidistant between the actuator and panel or PCB edge, where the sensitivity is half that of the uncontrolled anti-node value.

An additional disadvantage of using the known strain sensor to detect vibration for this type of application is that the panel must flex in order to derive an input signal for the control electronics. Thus, low levels of vibration cannot be controlled since this implies infinite gain from the control system.

US 4565940-A discloses an active vibration control for a planar member in accordance with the preamble of claim 1. US 5170103 discloses a vibration control for a tool head of a machine tool which uses piezoelectric elements as part of the damping device.

The present invention is concerned with overcoming the above discussed problem.

Accordingly, there is provided a method of actively damping the vibrations of a vibrating planar member by mounting a piezoelectrical actuator and an accelerometer on the vibrating planar member and applying a signal from the accelerometer to the actuator, such that the actuator applies a force to the vibrating planar member to damp the vibrations therein, characterised in that the accelerometer is mounted on the surface of the actuator remote from the planar member and both the accelerometer and actuator are located substantially at the maximum antinode of the planar member.

Also according to the present invention there is provided an active vibration control device damping the vibrations of a vibrating planar member and comprising a piezoelectric actuator and an accelerometer, the actuator being expandable and contractible along the plane of the member in response to an electric signal, and the accelerometer producing a signal representative of acceleration in a direction perpendicular to the plane of the member, the acceleration signal controlling the actuator to apply a damping force to the planar member. Such a device is known form US-A-4 565 940. The invention is characterised in that the accelerometer is secured to the surface of the actuator opposite to the surface provided for mounting the actuator on the planar member.

How the invention may be carried out will now be described by way of example only and with reference to the accompanying drawings in which:
Figure 1 illustrates schematically a known mounting arrangement for a sensor and actuator on a planar member;
Figure 2 is a fragmentary perspective view, to a larger scale, of the arrangement shown in figure 1;
Figure 3 is a schematic diagram illustrating the sensor/actuator control feedback loop; and
Figure 4 is similar to Figure 1 but illustrates the present invention.

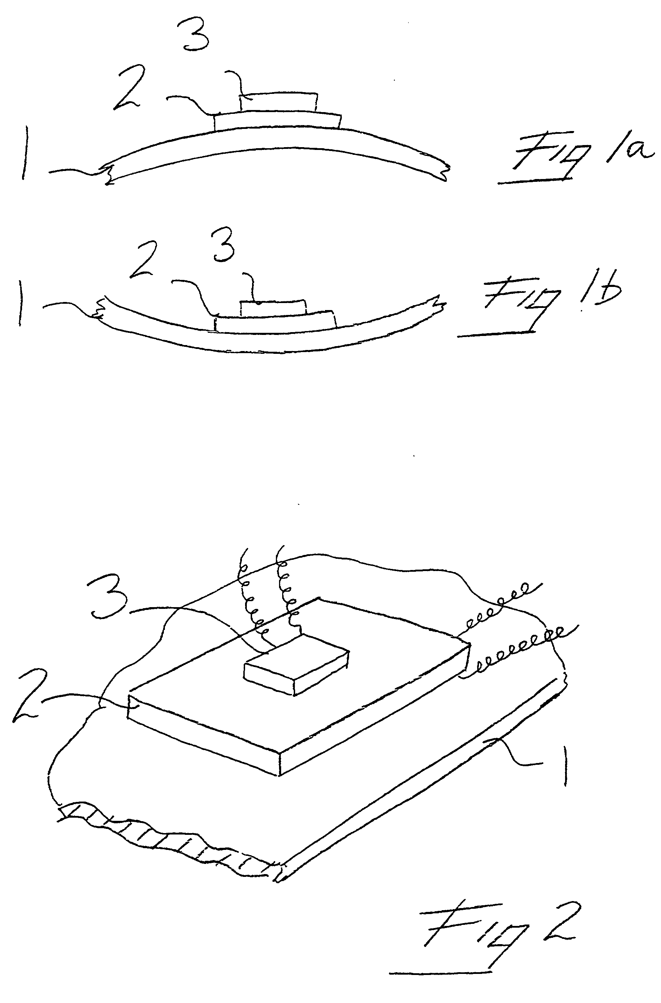

Referring to Figure 1, in a known arrangement using a strain sensor the planar panel 1, the vibration of which is to be controlled, has a piezoelectric actuator 2 mounted on it, e.g. by means of adhesive and a strain sensor 3 mounted on the actuator 2 again by means of adhesive, for example.

The reason the actuator and sensor are mounted in the same position on the panel 1 is because this is the optimum position for both sensing any vibration of the panel and for applying a corrective force to the panel in order to reduce or eliminate that vibration. The position selected for mounting the actuator 2 and strain sensor 3 will depend upon the characteristics of the panel but would preferably be at the maximum anti-node of vibration.

There are a number of disadvantages with this known arrangement. Firstly, the strain sensor 3 must be subject to strain in order to produce an electrical output. Consequently the panel must actually vibrate for the electronic control system to operate. This means in practice that there can be no control of the vibration below a certain minimum level of deflection of the panel 1, i.e. there is a dead zone where the active vibration control is ineffective.

In addition to this problem there is a further problem concerning the sensitivity of the arrangement in that by mounting the strain sensor 3 on the actuator 2 the sensor 3 is actually directly measuring the flexing of the actuator 2 and only indirectly measuring the flexing of the panel 1. Therefore, because the actuator 2 flexes less than the panel 1 it follows that the sensitivity of the strain sensor 3 to the flexing of the panel 1 is less than it would otherwise be if the strain sensor was mounted directly on the panel 1. However, if that were done the strain sensor 3 could not be co-located with the actuator with respect to the anti-node of the vibrating panel 1 and although it would gain in sensitivity for having been mounted directly on the panel 1 it would lose in sensitivity because of being in an area which is subject to a lesser amplitude of flexing.

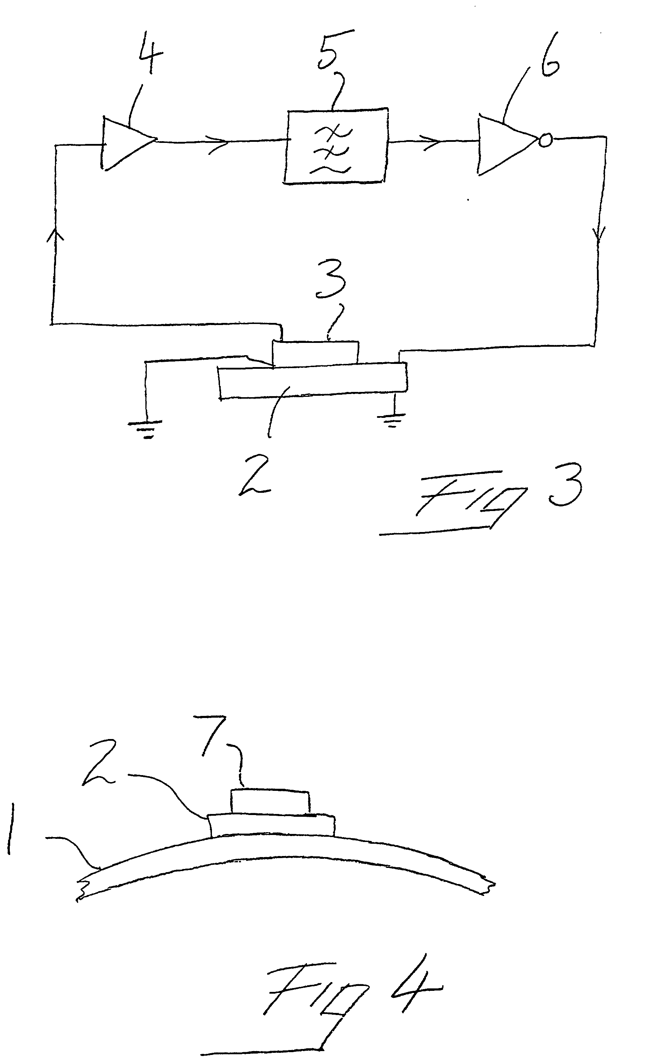

Figure 2 shows the mounting of the actuator 2 on the panel 1 and the sensor 3 on the actuator 2 in more detail and Figure 3 shows the electrical control circuit whereby active vibration control is effected.

Referring to Figure 3, the sensor generates a voltage as a result of the piezoelectric actuator 2 being flexed by vibration of the panel. The output from the sensor 3 is amplified by an amplifier 4, filtered by a filter 5, phase inverted by an inverter 6 and the resulting signal applied to the piezoelectric actuator 2.

The application of this signal to the actuator has the effect of contracting the area of the actuator to in turn apply a similar force to the panel 1 in order to counteract the force tending to flex that panel into the shape shown in Figure 1(a).

Similarly at the point in the vibration cycle where the panel 1 is flexing in the opposite direction, shown in Figure 1(b), the effect of that flexing is to cause the sensor 3 to generate a signal which when applied to the piezoelectric actuator 2 will cause the latter to expand and thus tend to counteract the force causing the panel to flex into the configuration shown in Figure 1(b).

As indicated earlier in connection with Figure 1 there are a number of disadvantages with this known arrangement.

The present invention overcomes the disadvantages by the use of a sensor which is in the form of an accelerometer sensor 7 instead of in the form of a strain measuring device such as the sensor 3. Thus with the present invention instead of the sensor 3 indirectly measuring the displacement of the panel 1 by measuring the displacement of the actuator 2, the accelerometer sensor 7 of the present invention measures directly the rate of change of the displacement, i.e. the second derivative of the movement of the panel, in order to provide the correcting signal which is then applied to the piezoelectric actuator in the manner already described with reference to Figure 3.

Because the accelerometer sensor 7 detects the actual movement of the panel 1 in the direction of the arrow A shown in Figure 4 (and not the surface expansion, or contraction of the actuator 2, and indirectly that of the panel 1 as does the strain sensor 3) the accelerometer sensor 7 directly detects the actual vibration of the panel 1.

Consequently by using the accelerometer sensor, in place of the strain sensor 3, the sensitivity of the arrangement is increased.

Furthermore, as a consequence of the accelerometer sensor 7 measuring deflection in the direct of the arrow A, because this deflection is the same for both the panel 1 and the actuator 2 there is no loss of sensitivity by having the accelerometer sensor 7 mounted directly on the actuator 2. Consequently it is possible to co-locate both the actuator 2 and the accelerometer sensor 7 in the same optimum position on the panel 1 without any consequential loss of sensitivity.

All accelerometers are internally referenced. This means it detects the acceleration to which it is subjected. If an accelerometer is fixed to a panel it will detect the acceleration of that point on the panel. If the entire structure on which the panel is mounted moves, the accelerometer will also detect that movement. Thus, if the panel moves, the control system will respond by stiffening the panel before it begins to deflect significantly.

It should be noted that the acceleration on the one hand and strain on the other hand of a vibrating panel are generally not in phase. It may therefore be thought that the use of an acceleration signal to control the actuator 2 and thus the vibration of the panel 1 would not be regarded as an appropriate solution to the above discussed problem. However, if the combined unit of the actuator 2 and accelerometer sensor 7 is located at the maximum anti-node then the acceleration and the strain are in phase with the result that the control system can be made stable.

A panel excited to vibrate will do so at its fundamental resonant frequency. Positioning of the sensor/actuator unit on the fundamental anti-node therefore gives maximum suppression of the vibration. If a strain sensor is not located on the fundamental anti-node the system sensitivity is decreased, as explained earlier. However if an accelerometer sensor is not located on the fundamental anti-node it will also be responsive to the acceleration of the structure to which the panel is attached. This disconnection between the sensing and actuating elements can easily result in an unstable control system. Hence it is important to locate an accelerometer sensor on the maximum anti-node.

In practice the piezoelectric actuator 2 and the accelerometer sensor 7 would be produced as a unit for securing to whatever planar element's vibration it was required to control.

The accelerometer sensor 7 can be secured to the piezoelectric actuator 2 by any simple means such as by adhesives, solders or mechanical fastenings.

## Claims

1. A method of actively damping the vibrations of a vibrating planar member (1) by mounting a piezoelectrical actuator (2) and an accelerometer (7) on the vibrating planar member (1) and applying a signal from the accelerometer (7) to the actuator (2), such that the actuator (2) applies a force to the vibrating planar member to damp the vibrations therein, **characterised in that** the accelerometer (7) is mounted on the surface of the actuator remote from the planar member and both the accelerometer and actuator are located substantially at the maximum antinode of the planar member.

2. A method as claimed in claim 1, **characterised in that** the planar member (1) is a printed circuit board.

3. A method as claimed in Claim 1 or Claim 2 , **characterised in that** the actuator (2) and accelerometer (7) are combined as a single unit.

4. An active vibration control device damping the vibrations of a vibrating planar member (1) and comprising a piezoelectric actuator (2) and an accelerometer (7), **characterised in that** the accelerometer (7) is mounted on the surface of the actuator (2) opposite to the surface provided for mounting the actuator (2) on the planar member (1), and **in that** the actuator (2) is expandable and contractible along the plane of the member (1) in response to an electric signal, and the accelerometer produces a signal representative of acceleration in a direction perpendicular to the plane of the member, the acceleration signal controlling the actuator to apply a damping force to the planar member.

5. A printed circuit board including an active vibration control device as claimed in Claim 4.

## Patentansprüche

1. Verfahren der aktiven Dämpfung der Schwingungen eines schwingenden ebenen Elements (1) durch Befestigen eines piezcelektrischen Stellglieds (2) und eines Beschleunigungsmessers (7) auf dem schwingenden ebenen Element (1) und durch Anlegen eines Signals von dem Beschleunigungsmesser (7) an das Stellglied (2) in solcher Weise, dass das Stellglied (2) eine Kraft auf das schwingende ebene Element ausübt, um die Schwingungen in diesem zu dämpfen,
**dadurch gekennzeichnet,**
**dass** der Beschleunigungsmesser (7) auf der von dem ebenen Element entfernten Oberfläche des Stellglieds befestigt ist und dass sowohl der Beschleunigungsmesser als auch das Stellglied im Wesentlichen im maximalen Schwingungsbauch des ebenen Elements angeordnet sind.

2. Verfahren nach Anspruch 1,
**dadurch gekennzeichnet,**
**dass** das ebene Element (1) eine gedruckte Schaltungsplatine ist.

3. Verfahren nach Anspruch 1 oder Anspruch 2,
**dadurch gekennzeichnet,**
**dass** das Stellglied (2) und der Beschleunigungsmesser (7) als eine einzige Einheit kombiniert sind.

4. Aktive Schwingungsregelungsvorrichtung, welche die Schwingungen eines schwingenden ebenen Elements (1) dämpft und ein piezoelektrisches Stellglied (2) und einen Beschleunigungsmesser (7) umfasst,
**dadurch gekennzeichnet,**
**dass** der Beschleunigungsmesser (7) auf jener Oberfläche des Stellglieds (2) befestigt ist, welche der zur Befestigung des Stellglieds (2) auf dem ebenen Element (1) vorgesehenen Fläche gegenüberliegt, und dadurch, dass sich das Stellglied (2) in Ansprechen auf ein elektrisches Signal entlang der Ebene des Elements (1) ausdehnen und zusammenziehen kann und dass der Beschleuingungsmesser ein Signal erzeugt, welohes die Beschleunigung in einer zur Ebene des Elements senkrechten Richtung repräsentiert, wobei das Beschleunigungssignal das Stellglied dazu steuert, eine dämpfende Kraft auf das ebene Element auszuüben.

5. Gedruckte Schaltungsplatine, welche eine aktive Schwingungsregelungsvorrichtung nach Anspruch 4 aufweist.

## Revendications

1. Procédé pour amortir de manière active les vibrations d'un élément plan vibrant (1) en montant un actionneur piézoélectrique (2) et un accéléromètre (7) sur l'élément plan vibrant (1) et en appliquant un signal à partir de l'accéléromètre (7) à l'actionneur (2), de sorte que l'actionneur (2) applique une force à l'élément plan vibrant afin d'amortir les vibrations sur celui-ci, **caractérisé en ce que** l'accéléromètre (7) est monté sur Ia surface de l'actionneur d'une manière éloignée par rapport à l'élément plan et à la fois l'accéléromètre et l'actionneur sont placés sensiblement au niveau du ventre maximum de l'élément plan.

2. Procédé selon la revendication 1, **caractérisé en ce que** l'élément plan (1) est une carte à circuit imprimé.

3. Procédé selon la revendication 1 ou la revendication 2, **caractérisé en ce que** l'actionneur (2) et l'accéléromètre (7) sont combinés en une seule unité.

4. Dispositif de régulation de vibration actif amortissant les vibrations d'un élément plan vibrant (1) et comprenant un actionneur piézoélectrique (2) et un accéléromètre (7), **caractérisé en ce que** l'accéléromètre (7) est monté sur la surface de l'actionneur (2) à l'opposé de la surface prévue pour le montage de l'actionncur (2) sur l'élément plan (1), et **en ce que** l'actionneur (2) peut s'étendre et se contracter le long du plan de l'élément (1) en réponse à un signal électrique, et l'accéléromètre produit un signal représentatif de l'accélération dans une direction perpendiculaire au plan de l'élément, le signal d'accélération commandant l'actionneur afin d'appliquer une force d'amortissement à l'élément plan.

5. Carte à circuit imprimé comprenant un dispositif de régulation de vibration actif selon la revendication 4.
